# EUROPEAN PATENT APPLICATION

(11) **EP 4 703 135 A1**
(43) Date of publication of application: **04.03.2026**
(21) Application number: 24797109.6
(22) Date of filing: 25.04.2024
(51) Int. Cl.: B32B 27/00, B32B 27/34, B32B 27/40, H05K 1/03

(54) **LAMINATE, METHOD FOR PRODUCING LAMINATE, AND METHOD FOR PRODUCING PRINTED WIRING BOARD**

(30) Priority: 28.04.2023 JP 2023074510
(71) Applicant: Tatsuta Electric Wire & Cable Co., Ltd., Higashiosaka-shi, Osaka 578-8585 (JP)
(72) Inventor: TAKESHITA, Sigeki, Kizugawa-shi, Kyoto 619-0216 (JP); IWAI, Kiyoshi, Kizugawa-shi, Kyoto 619-0216 (JP)
(74) Representative: Maiwald GmbH
(86) International application number: PCT/JP2024/016187
(87) International publication number: WO 2024/225364

(57) **Abstract**

Provided is a laminate in which a protective layer is uniformly deposited on a separator and the separator after thermocompression bonding has a peel strength that is not excessively high. The laminate of the present invention is a laminate that includes: a separator including a substrate and a disposed on a surface of the substrate, the silicone resin film serving as a release surface; and a protective layer deposited on the separator and in contact with the release surface. The release surface has a water contact angle of 107.1° or greater. The protective layer contains at least one resin selected from the group consisting of polyurethane resin, polyamide-imide resin, and polyamide resin.

## Description

### TECHNICAL FIELD

The present invention relates to a laminate, a method for producing a laminate, and a method for producing a printed wiring board.

### BACKGROUND ART

The increased performance of electronic devices, along with the resulting higher integration of electric circuits, has recently promoted higher precision and greater density in printed wiring boards.

An electric circuit of a printed wiring board may be formed by a method in which an electric circuit is first formed on a transfer film, which is then transferred to a base material.

An example of this transfer film is a laminate of a separator, a protective layer, conductive paste, which serves as an electric circuit, and an adhesive resin stacked in the stated order.

In the case of transferring an electric circuit to a base material using this transfer film, the transfer film is first placed on the base material such that the adhesive resin of the transfer film is in contact with the base material.

Then, the transfer film is thermocompression-bonded to the base material. In this step, the conductive paste is hardened into an electric circuit.

Finally, the separate film is peeled off the workpiece, thereby producing a printed wiring board with the adhesive resin, the electric circuit, and the protective layer being transferred to the base material.

For a separator of such a transfer film, Patent Literature 1 discloses the following polyester film.

Specifically, Patent Literature 1 discloses a polyester film including a polyester A layer on at least one side of a polyester B layer, wherein the polyester A layer constitutes at least one surface layer of the polyester film and contains 5% by mass or more and 30% by mass or less of polyester having a butylene terephthalate repeating unit, and wherein the surface of the polyester A layer has a center line average roughness Ra of 0.20 µm or higher and 1.00 µm or lower and a water contact angle of 70° or greater and 84° or smaller.

### CITATION LIST

### - Patent Literature

Patent Literature 1: JP 2022-1431 A

### SUMMARY OF INVENTION

### - Technical Problem

In order to improve the peelability of a separator, a method is known in which a silicone resin film is formed on a surface of the separator.

When an attempt is made to deposit a protective layer on the silicone resin film of the separator, however, the separator repels the protective layer and prevents uniform formation of the protective layer.

Another problem is an excessively high peel strength during peeling of the separator of the transfer film after thermocompression bonding, which causes partial adhesion of the protective layer to the separator or a break of the protective layer.

The present invention is made to solve the above problems and aims to provide a laminate in which a protective layer is uniformly deposited on a separator and the separator after thermocompression bonding has a peel strength that is not excessively high.

### - Solution to problem

In other words, the laminate of the present invention includes a separator including a substrate and a silicone resin film disposed on a surface of the substrate, the silicone resin film serving as a release surface; and a protective layer deposited on the separator and in contact with the release surface, the release surface having a water contact angle of 107.1° or greater, the protective layer containing at least one resin selected from the group consisting of polyurethane resin, polyamide-imide resin, and polyamide resin.

A silicone resin film has the property of repelling resin deposited thereon by printing, for example.

In common cases, the greater the water contact angle on a silicone resin film (i.e., a release surface), the better the silicone resin film repels resin.

Surprisingly, however, the present inventors have found that resin is less likely to be repelled by the silicone resin film in the case where the resin is at least one resin selected from the group consisting of polyurethane resin, polyamide-imide resin, and polyamide resin.

The present invention is made on the basis of this finding.

In the laminate of the present invention, the protective layer contains at least one resin selected from the group consisting of polyurethane resin, polyamide-imide resin, and polyamide resin.

As described above, these resins are less likely to be repelled by a silicone resin film. This enables uniform formation of a protective layer.

The phrase "a protective layer is uniform" herein means that, when the laminate is observed from the protective layer side, the protective layer formed on the release surface of the separator has no repelled portion and the release surface of the separator is not visually observed.

In the laminate of the present invention, the release surface having a water contact angle of 107.1° or greater allows the separator to have a low peel strength after thermocompression bonding of the laminate of the present invention.

A release surface having a water contact angle smaller than 107.1° causes resin to be easily repelled by the silicone resin film, hindering uniform formation of a protective layer.

The laminate of the present invention may further include a conductive material layer deposited on the protective layer, the conductive material layer being positioned opposite the separator with the protective layer in between.

Using the laminate of the present invention enables transfer of the conductive material layer to a base material.

In the laminate of the present invention, the conductive material layer may be a conductive paste layer for forming an electric circuit.

**In** comparison with direct formation of an electric circuit on a base material, a more minute electric circuit can be obtained by transfer formation of an electric circuit through the steps of forming a conductive paste layer for forming an electric circuit on the laminate, which serves as a transfer film, and transferring this conductive paste layer for forming an electric circuit to a base material.

The laminate of the present invention may further include an adhesive resin layer deposited on and covering the conductive material layer, the adhesive resin layer being positioned opposite the separator with the protective layer in between.

This adhesive resin layer allows a transfer target deposited on the separator to be transferred to a base material.

The method for producing the laminate of the present invention includes:
a separator preparation step of forming, as a separator, a silicone resin film on a surface of a substrate, the silicone resin film serving as a release surface; and
a protective layer formation step of depositing a protective layer on the release surface,
wherein
in the separator preparation step, the silicone resin film is formed to cause the release surface to have a water contact angle of 107.1° or greater, and
the protective layer contains at least one resin selected from the group consisting of polyurethane resin, polyamide-imide resin, and polyamide resin.

The method for producing a laminate of the present invention can provide the laminate of the present invention.

The method for producing a printed wiring board of the present invention includes: a laminate preparation step of preparing a laminate, the laminate including:
a separator including a substrate and a silicone resin film deposited on a surface of the substrate, the silicone resin film serving as a release surface;
a protective layer disposed on the separator and in contact with the release surface,
a conductive material layer deposited on the protective layer, the conductive material layer being positioned opposite the separator with the protective layer in between, and
an adhesive resin layer deposited on and covering the conductive material layer, the adhesive resin layer being positioned opposite the separator with the protective layer in between;

a laminate placement step of placing the laminate with the adhesive resin layer being bonded to a base material;
a thermocompression bonding step of thermocompression-bonding the laminate to the substrate, and
a peeling step of peeling the separator,
the release surface having a water contact angle of 107.1° or greater, and
the protective layer containing at least one resin selected from the group consisting of polyurethane resin, polyamide-imide resin, and polyamide resin.

In the method for producing a printed wiring board of the present invention, the release surface (silicone resin film) of the separator has a water contact angle of 107.1° or greater, and the protective layer contains at least one resin selected from the group consisting of polyurethane resin, polyamide-imide resin, and polyamide resin.

Since these components are compatible with each other, the peel strength between the release surface of the separator and the protective layer does not become excessively high after thermocompression bonding of the laminate and the separator can be favorably peeled off in the peeling step.

### - Advantageous Effects of Invention

The present invention can provide a laminate in which a protective layer is uniformly deposited on a separator and the separator after thermocompression bonding has a peel strength that is not excessively high.

### BRIEF DESCRIPTION OF DRAWINGS

FIG. 1A is a schematic perspective view of an example of the laminate of the invention.
FIG. 1B is a cross-sectional view taken along the A-A line in FIG. 1A.
FIG. 2A is a schematic view of an example of the separator preparation step in the method for producing a laminate of the present invention.
FIG. 2B is a schematic view of an example of the separator preparation step in the method for producing a laminate of the present invention.
FIG. 3 is a schematic view of an example of the protective layer formation step in the method for producing a laminate of the present invention.
FIG. 4 is a schematic view of an example of a transfer target deposition step in the method for producing a laminate of the present invention.
FIG. 5A is a schematic view of an example of a deposition step in the method for producing a printed wiring board of the present invention.
FIG. 5B is a schematic view of an example of the thermocompression bonding step in the method for producing a printed wiring board of the present invention.
FIG. 5C is a schematic view of an example of the peeling step in the method for producing a printed wiring board of the present invention.
FIG. 6A is a photograph of an example of the rating "o" in the repellency evaluation.
FIG. 6B is a photograph of an example of the rating "Δ" in the repellency evaluation.
FIG. 6C is a photograph of an example of the rating "×" in the repellency evaluation.

### DESCRIPTION OF EMBODIMENTS

The following specifically describes the laminate of the present invention, a method for producing this laminate, and a method for producing a printed wiring board using this laminate. Still, the present invention is not limited to the following embodiments, and may be appropriately modified within the scope where the gist of the invention is not changed.

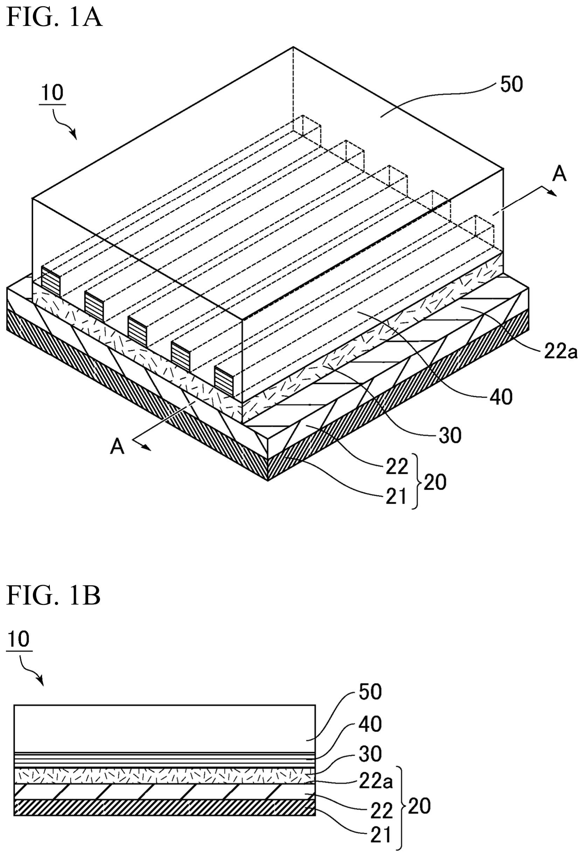

FIG. 1A is a schematic perspective view of an example of the laminate of the invention.

FIG. 1B is a cross-sectional view taken along the A-A line in FIG. 1A.

A laminate 10 shown in FIG. 1A and FIG. 1B includes a separator 20 including a substrate 21 and a silicone resin film 22 disposed on a surface of the substrate 21, the silicone resin film 22 serving as a release surface 22a, and a protective layer 30 deposited on the separator 20 and in contact with the release surface 22a.

The laminate 10 further includes a conductive material layer 40 and an adhesive resin layer 50 deposited on the protective layer 30 in the stated order.

In other words, the conductive material layer 40 is deposited on the protective layer 30, the conductive material layer 40 being positioned opposite the separator 20 with the protective layer 30 in between.

Also, the adhesive resin layer 50 is deposited on and covering the conductive material layer 40, the adhesive resin layer 50 being positioned opposite the separator 20 with the protective layer 30 in between.

The protective layer 30 of the laminate 10 contains at least one resin selected from the group consisting of polyurethane resin, polyamide-imide resin, and polyamide resin.

These resins are compatible with the silicone resin film 22 and are less likely to be repelled by the silicone resin film 22. This enables uniform formation of the protective layer 30.

The release surface 22a of the laminate 10 has a water contact angle of 107.1° or greater.

The water contact angle of the release surface 22a is preferably 109 to 120°, more preferably 110 to 115°, still more preferably 110 to 113.5°.

To be specifically described later, the laminate 10 is thermocompression-bonded to a base material.

The release surface 22a having a water contact angle of 107.1° or greater allows the separator 20 to have a low peel strength after thermocompression bonding of the laminate 10. This enables easy peeling of the separator 20.

A release surface having a water contact angle smaller than 107.1° causes resin to be easily repelled by the silicone resin film and hinders uniform formation of the protective layer.

The "water contact angle" of the release surface herein means the contact angle of the release surface relative to pure water measured using a contact angle meter (product name: Portable contact angle meter PCA-11, manufacturer: Kyowa Interface Science Co., Ltd.).

The following specifically describes the components of the laminate.

### (Separator)

The substrate 21 of the separator 20 may be, but is not limited to, polyethylene naphthalate (PEN) or polyethylene terephthalate (PET).

The substrate 21 is preferably in the form of sheet and has a thickness of preferably 6 to 100 µm, more preferably 12 to 100 µm.

A substrate having a thickness smaller than 6 µm may be easily broken.

A substrate having a thickness greater than 100 µm may transfer less heat and thus cause a failure in compression bonding.

The substrate 21 has a surface provided with the silicone resin film 22. The silicone resin film 22 forms the release surface 22a of the separator 20.

Examples of the silicone resin film 22 include an emulsion-type film prepared by emulsifying silicone oil, a solution-type film prepared by diluting a silicone resin in toluene or petroleum-based hydrocarbon, a baking-type film prepared by diluting a silicone resin in petroleum-based hydrocarbon, volatilizing the solvent, and baking the residue at high temperature to form a film, and a spray-type film which is ready for use. Preferred in the present invention is a solution-type film.

Specific examples of the separator 20 provided with the silicone resin film 22 and thus having a release surface include NS-75-G available from Nakamoto Packs Co., Ltd., E7001 available from Toyobo Co., Ltd., E7002 available from Toyobo Co., Ltd., and E7006 available from Toyobo Co., Ltd.

In particular, the dry weight of the silicone resin film 22 is preferably 0.01 to 1 g/m², more preferably 0.05 to 0.8 g/m².

A silicone resin film having a dry weight less than 0.01 g/m² may give a less effect of forming a silicone resin film and lead to high peel strength.

A silicone resin film having a dry weight more than 1 g/m² may give an effect of forming a silicone resin film nearly at its maximum and is not cost-effective.

The silicone resin film 22 may contain a cross-linker, a catalyst, a reaction inhibitor, an adhesion improver, or the like in addition to the resin.

The water contact angle of the release surface 22a of the separator 20 can be adjusted by selecting the amount and type of the silicone resin film 22 applied.

### (Protective layer)

The protective layer 30 of the laminate 10 contains at least one resin selected from the group consisting of polyurethane resin, polyamide-imide resin, and polyamide resin.

In the case where the protective layer 30 contains polyurethane resin, the protective layer 30 has improved stretchability. This is useful for the case where a printed wiring board produced using the laminate 10 needs stretchability.

In the case where the protective layer 30 contains polyamide-imide resin and/or polyamide resin, the protective layer 30 has improved heat resistance. This is useful for the case where a printed wiring board produced using the laminate 10 needs heat resistance.

In the case where the protective layer 30 needs stretchability in a printed wiring board produced using the laminate 10, the protective layer 30 may contain polyurethane elastomer.

The polyurethane elastomer is composed of hard segments and soft segments. Examples of the soft segments include a carbonate, an ester, and an ether. For the physical properties thereof, the elongation at break is preferably 20 to 500%, more preferably 30 to 500%.

The protective layer 30 has a thickness of preferably 3 to 60 µm, more preferably 5 to 50 µm.

A protective layer having a thickness smaller than 3 µm may be easily broken. This may hinder sufficient protection of the electric circuit, which is a protection target of the protective layer, in a printed wiring board produced using the laminate.

A protective layer having a thickness greater than 60 µm is likely to have reduced flexibility. Such a protective layer is therefore less applicable to components that need bending resistance.

The protective layer 30 may optionally contain a curing accelerator, a tackifier, an antioxidant, a pigment, a dye, a plasticizer, an ultraviolet absorber, a defoamer, a leveling agent, a filler, a flame retardant, a viscosity modifier, an anti-blocking agent, or the like.

### (Conductive material layer)

The conductive material layer 40 may be any layer that can form an electric circuit in production of a printed wiring board using the laminate 10.

For example, the conductive material layer 40 may be a conductive paste layer or a metal layer.

Examples of the metal layer include a vapor-deposited layer, a plated layer, and a metal layer formed by etching.

The conductive paste layer may contain conductive filler and resin.

Examples of the conductive filler include copper powder, silver powder, silver-coated copper powder, silver-coated nickel powder, copper-coated nickel powder, graphite, and carbon nanotube.

The conductive filler may be in the form of dendrites, coils, bulks, spheres, flakes, needles, or fibers. The form of dendrites refers to the form composed of a rod-shaped main branch and rod-shaped small branches extending from the main branch in the two- or three-dimensional directions. The form of dendrites encompasses the form in which small branches exhibit bends at their intermediate points and the form in which other rod-shaped small branches extend from intermediate points of the former small branches.

The conductive filler has a particle size (average particle size D₅₀) of preferably 0.01 to 50 µm, more preferably 0.02 to 30 µm.

With a particle size of 0.01 µm or greater, particles of the conductive filler can easily contact each other, resulting in good conductivity of a conductive composition.

With a particle size of 50 µm or smaller, the conductive filler ensures printability and smoothness of the conductive material layer.

The conductive paste layer preferably contains 50 to 95% by weight of the conductive filler.

Examples of the resin include epoxy resin, phenol resin, polyimide resin, and polyamide-imide resin.

In the case where the electric circuit needs stretchability in a printed wiring board produced using the laminate 10, the resin may be elastomeric resin.

Examples of the elastomeric resin include resins having elasticity such as a styrenic elastomer, an olefinic elastomer, a polyester elastomer, a polyurethane elastomer, a polyamide elastomer, and a silicone elastomer.

The polyurethane elastomer is composed of hard segments and soft segments. Examples of the soft segments include a carbonate, an ester, and an ether. For the physical properties thereof, the elongation at break is preferably 20 to 500%, more preferably 30 to 500%.

The metal of a vapor-deposited layer, a plated layer, or a metal layer formed by etching is commonly, but not limited to, copper.

The conductive material layer 40 has a thickness of preferably 3 to 60 µm, more preferably 5 to 50 µm.

### (Adhesive resin layer)

The adhesive resin layer 50 preferably contains a hot-melt-adhesive resin.

Examples of the hot-melt-adhesive resin include thermoplastic resins such as polyester resin, polyurethane resin, polyamide resin, olefinic resin, and ethylene-vinyl acetate resin.

These thermoplastic resins preferably have a softening point of 170°C or lower and an elongation at break of 300% or higher, more preferably a softening point of 150°C or lower and an elongation at break of 500% or higher.

Specific examples of these thermoplastic resins include polyurethane thermoplastic resins such as trade name "SHM101-PUR" available from Sheedom Co., Ltd.

Next, the method for producing a laminate of the present invention is described.

The method for producing a laminate of the present invention includes a separator preparation step and a protective layer formation step.

Also, the method for producing a laminate of the present invention may further include a transfer target deposition step of depositing a transfer target on the protective layer.

The following specifically describes the individual steps.

### (Separator preparation step)

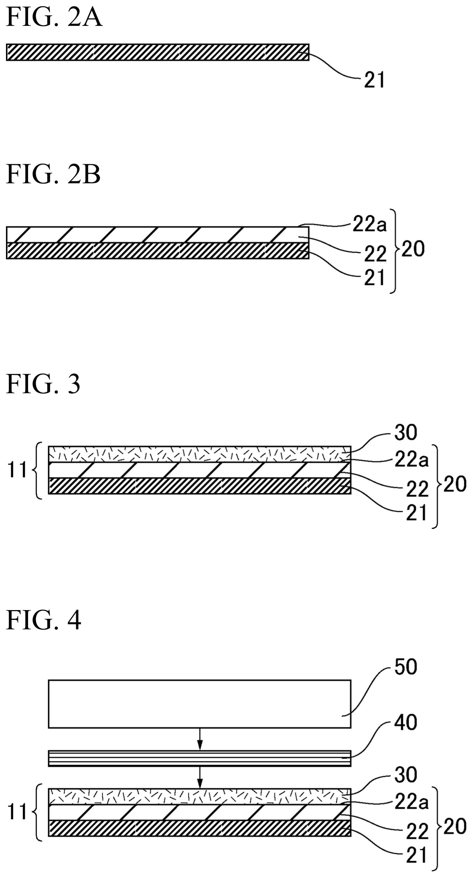

FIG. 2A and FIG. 2B are each a schematic view of an example of the separator preparation step in the method for producing a laminate of the present invention.

In the separator preparation step, as shown in FIG. 2A, a substrate 21 is first prepared.

The substrate 21 can be formed by extrusion-molding a material into a desired shape and size.

Next, as shown in FIG. 2B, a silicone resin film 22, which serves as a release surface 22a, is formed on a surface of the substrate 21.

In this step, the silicone resin film 22 is formed to cause the release surface 22a to have a water contact angle of 107.1° or greater.

The release surface 22a is preferably formed to have a water contact angle of 109 to 120°, more preferably 110 to 115°, still more preferably 110 to 113.5°.

The silicone resin film 22 can be formed by applying, heating, and drying a silicone resin film-forming composition containing silicone resin and a solvent.

Examples of the solvent include toluene, acetone, methyl ethyl ketone, methanol, ethanol, propanol, and dimethyl formamide.

The solid concentration in the silicone resin film-forming composition is preferably determined as appropriate depending on the thickness of the silicone resin film 22, for example.

The silicone resin film-forming composition may be applied by any method and may be applied with a known coater.

For example, the silicone resin film 22 may be formed using a coater such as a gravure roll coater, a reverse roll coater, a kiss roll coater, a lip coater, a dip roll coater, a bar coater, a knife coater, a spray coater, a comma coater, a direct coater, or a slot die coater.

Since preferred materials and other factors of the substrate 21 and the silicone resin film 22 are described above, they are not further elaborated here.

### (Protective layer formation step)

In the protective layer formation step, as shown in FIG. 3, a protective layer 30 is deposited on the release surface 22a.

The protective layer 30 may be formed by a method in which a protective layer-forming composition containing a protective layer resin and a solvent is provided by a coating technique and then heated and dried, or may be formed by a method in which this protective layer-forming composition is provided by printing.

Since a preferred resin for the protective layer contained in the protective layer-forming composition is the same as the resin of the protective layer, it is not further elaborated here.

Examples of the solvent contained in the protective layer-forming composition include toluene, acetone, methyl ethyl ketone, methanol, ethanol, propanol, dimethyl formamide, N-methylpyrrolidone, γ-butyrolactone, butylcarbitol acetate, and butyl cellosolve.

In the case where the protective layer-forming composition has a solid concentration that falls within the above range, the protective layer-forming composition is less likely to be repelled by the silicone resin film 22, which enables uniform formation of the protective layer 30.

The protective layer-forming composition may be applied by coating by any method and may be applied with a known coater.

For example, the protective layer 30 may be formed using a coater such as a gravure roll coater, a reverse roll coater, a kiss roll coater, a lip coater, a dip roll coater, a bar coater, a knife coater, a spray coater, a comma coater, a direct coater, or a slot die coater.

Examples of methods for printing the protective layer-forming composition include gravure printing, flexo printing, offset printing, screen printing, and rotary screen printing.

The protective layer-forming composition is preferably treated under heating and drying conditions including 100°C to 250°C for 2 to 60 minutes.

The aforementioned steps can produce a laminate 11 including the separator 20 and the protective layer 30 deposited.

The laminate 11 produced as described corresponds to the laminate of the present invention.

### (Transfer target deposition step)

FIG. 4 is a schematic view of an example of the transfer target deposition step in the method for producing a laminate of the present invention.

Next, as shown in FIG. 4, a conductive material layer 40, which is a transfer target, and an adhesive resin layer 50 are deposited on the protective layer 30 in the stated order.

The conductive material layer 40 and the adhesive resin layer 50 can be deposited by a conventionally known method.

The aforementioned step can produce a laminate 10 as shown in FIG. 1A.

Next, a method for producing a printed wiring board using the laminate of the present invention is described.

The method for producing a printed wiring board of the present invention includes a laminate preparation step, a laminate placement step, a thermocompression bonding step, and a peeling step.

The following describes the individual steps.

### (Laminate preparation step)

In the method for producing a printed wiring board of the present invention, a laminate 10 is first prepared.

Since the structure of the laminate 10 is described above, it is not further elaborated here.

### (Laminate placement step)

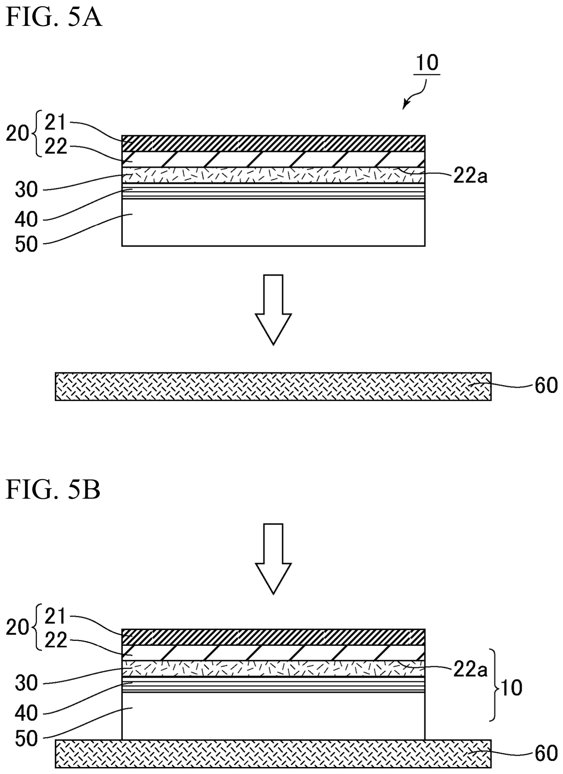

FIG. 5A is a schematic view of an example of the deposition step in the method for producing a printed wiring board of the present invention.

In the laminate placement step, as shown in FIG. 5A, the laminate 10 is placed with the adhesive resin layer 50 being bonded to a base material 60.

The laminate 10 shown in FIG. 5A is an upside-down version of the laminate 10 shown in FIG. 1A.

The base material 60 is preferably formed from, but not limited to, engineering plastic. Examples of the engineering plastic include resins such as polypropylene, crosslinked polyethylene, polyester, polybenzimidazole, polyimide, polyimide-amide, polyetherimide, and polyphenylene sulfide (PPS), woven fabric, stretch woven fabric, nonwoven fabric, and stretch nonwoven fabric.

### (Thermocompression bonding step)

FIG. 5B is a schematic view of an example of the thermocompression bonding step in the method for producing a printed wiring board of the present invention.

Next, as shown in FIG. 5B, the laminate 10 is thermocompression-bonded to the base material 60 (in FIG. 5B, the arrow indicates the pressure direction).

The conditions for thermocompression bonding are preferably determined as appropriate in accordance with factors such as the composition of the adhesive resin layer 50 and the thickness of the separator 20. For example, the thermocompression bonding is preferably performed under the conditions including 60°C to 300°C, 0.1 to 3.0 MPa, and 5 to 300 seconds.

This step enables transfer of the adhesive resin layer 50, the conductive material layer 40, and the protective layer 30 to the base material 60.

In the case where the conductive material layer 40 is formed from a conductive paste layer, the thermocompression bonding hardens the conductive paste layer into an electric circuit.

### (Peeling step)

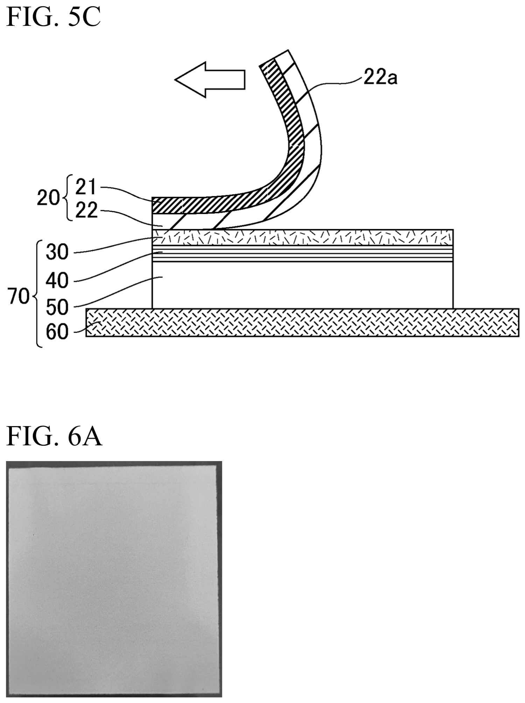

FIG. 5C is a schematic view of an example of the peeling step in the method for producing a printed wiring board of the present invention.

Next, as shown in FIG. 5C, the separator 20 is peeled off.

In the laminate 10, the release surface 22a, which is composed of the silicone resin film 22, has a water contact angle of 107.1° or greater and the protective layer 30 contains at least one resin selected from the group consisting of polyurethane resin, polyamide-imide resin, and polyamide resin.

Since these components are compatible with each other, the peel strength between the release surface 22a of the separator 20 and the protective layer 30 does not become excessively high after thermocompression bonding and the separator can be favorably peeled off in the peeling step.

The peel strength upon peeling of the separator is preferably 0.01 to 2 N/50 mm or higher, more preferably 0.05 to 1 N/50 mm.

This peel strength means a value determined under the conditions including room temperature, a tensile rate of 1000 mm/min, and a peeling angle of 170° using a peel strength tester (Palmec Co., Ltd., PFT50S).

The aforementioned steps can produce a printed wiring board 70 including the adhesive resin layer 50, the conductive material layer 40, which serves as an electric circuit, and the protective layer 30 deposited in the stated order on the base material 60.

### (Other embodiments)

The laminate 10 is used for transferring the electric circuit of the printed wiring board 70.

Still, as long as the laminate of the present invention includes a separator and a protective layer, the transfer target to be deposited on the protective layer is not necessarily a material for forming an electric circuit.

For example, the laminate of the present invention may be a laminate including a separator, a protective layer, and a shielding layer deposited in the stated order.

The laminate of the present invention may be a laminate including a separator, a protective layer, and a polarizing film deposited in the stated order.

In the laminate of the present invention, another layer such as a functional material layer, e.g., an anchor coat layer, may be deposited between the protective layer and the conductive material layer or between the conductive material layer and the adhesive resin layer.

### EXAMPLES

The present invention is more specifically described below with reference to examples, but the present invention is not limited to these examples.

### (Example 1)

### (Separator preparation step)

A substrate composed of a 75-µm-thick sheet-shaped polyethylene terephthalate was prepared.

Next, a silicone resin film-forming composition (release surface-forming composition) shown in Table 1 was applied to one surface of the substrate, then heated and dried, whereby a silicone resin film was formed. This was used as a release surface.

Thereby, a separator according to Example 1 was prepared.

Using a contact angle meter (product name: Portable contact angle meter PCA-11, manufacturer: Kyowa Interface Science Co., Ltd.), 2 µL of distilled water was dropped and the contact angle of the release surface after one second was measured in accordance with the sessile drop method. The results are shown in Table 1.

### (Protective layer formation step)

Next, a protective layer-forming composition having the composition shown in Table 1 was printed on the release surface of the separator with the length × width being 60 mm × 60 mm. The printing conditions were such that the composition was printed by hand screen printing and dried at 150°C for three minutes so that the protective layer had a thickness of 10 µm.

These steps produced a laminate according to Example 1.

### (Example 2) to (Example 6) and (Comparative Example 1) to (Comparative Example 8)

Except that the composition was changed as shown in Table 1 or Table 2, laminates of Example 2 to Example 6 and Comparative Example 1 to Comparative Examples 8 were produced.

**[Table 1]**

| | | Example 1 | Example 2 | Example 3 | Example 4 | Example 5 | Example 6 |
|---|---|---|---|---|---|---|---|
| Release surface-forming composition | Resin | Silicone resin 1 | Silicone resin 1 | Silicone resin 1 | Silicone resin 2 | Silicone resin 3 | Silicone resin 4 |
| Protective layer-forming composition | Resin | Acrylic urethane resin | Polyurethane resin | Polyamide-imide resin | Polyurethane resin | Polyurethane resin | Polyurethane resin |
| Water contact angle of release surface (°) | | 112.0 | 112.0 | 112.0 | 107.5 | 110.7 | 113.5 |
| Evaluation of appearance | | ∘ | ∘ | ∘ | ∘ | ∘ | ∘ |
| Evaluation of peel strength after thermocompression bonding | | 0.16 | 0.10 | 0.12 | 0.15 | 0.12 | 0.08 |

**[Table 2]**

| | | Comparative Example 1 | Comparative Example 2 | Comparative Example 3 | Comparative Example 4 | Comparative Example 5 | Comparative Example 6 | Comparative Example 7 | Comparative Example 8 |
|---|---|---|---|---|---|---|---|---|---|
| Release surface-forming composition | Resin | Silicone resin 1 | Silicone resin 1 | Silicone resin 1 | Non-silicone resin 1 | Non-silicone resin 2 | Silicone resin 5 | Silicone resin 6 | Silicone resin 7 |
| Protective layer-forming composition | Resin | Acrylic resin | Polycarbonate resin | Polyimide resin | Polyurethane resin | Polyurethane resin | Polyurethane resin | Polyurethane resin | Polyurethane resin |
| Water contact angle of release surface (°) | | 112.0 | 112.0 | 112.0 | 89.5 | 106.1 | 101.6 | 105.5 | 107.0 |
| Evaluation of appearance | | × | × | × | × | × | × | × | Δ |
| Evaluation of peel strength after thermocompression bonding | | 0.22 | 0.16 | 0.24 | 0.39 | 0.61 | 0.13 | 0.10 | 0.04 |

In Tables 1 and 2, the silicone resins serving as the release surface-forming composition in the respective separators are as follows.

Silicone resin 1: NS-75-G available from Nakamoto Packs Co., Ltd.

Silicone resin 2: water contact angle modified product 1 of NS-75-G available from Nakamoto Packs Co., Ltd.

Silicone resin 3: water contact angle modified product 2 of NS-75-G available from Nakamoto Packs Co., Ltd.

Silicone resin 4: water contact angle modified product 3 of NS-75-G available from Nakamoto Packs Co., Ltd.

Silicone resin 5: E7001 available from Toyobo Co., Ltd.

Silicone resin 6: E7002 available from Toyobo Co., Ltd.

Silicone resin 7: E7006 available from Toyobo Co., Ltd.

The non-silicone resins serving as the release surface-forming composition in the respective separators are as follows.

Non-silicone resin 1: R02N2 available from Nakamoto Packs Co., Ltd.

Non-silicone resin 2: F05N available from Nakamoto Packs Co., Ltd.

The protective layer-forming compositions are as follows.

Acrylic urethane resin: TPTF-9001N available from Goo Chemical Co., Ltd.

Polyurethane resin: RESAMINE CU-4104E available from Dainichiseika Color & Chemicals Mfg. Co., Ltd.

Polyamide-imide resin: HR-16NN available from Toyobo Co., Ltd.

Acrylic resin: PTF-60N available from Goo Chemical Co., Ltd.

Polycarbonate resin: TPTF-9500 available from Goo Chemical Co., Ltd.

Polyimide resin: PIAD200 available from Arakawa Chemical Industries, Ltd.

### <Evaluation of appearance>

The laminates of the examples and the comparative examples were observed from the protective layer side; specifically, whether the protective layer was repelled or not was visually observed. The results are shown in Tables 1 and 2.

The evaluation criteria in the evaluation of appearance are as described below and as shown in FIG. 6A to FIG. 6C.

FIG. 6A is a photograph of an example of the rating "o" in the repellency evaluation.

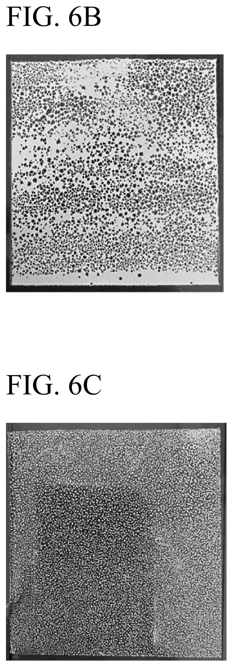

FIG. 6B is a photograph of an example of the rating "Δ" in the repellency evaluation.

FIG. 6C is a photograph of an example of the rating "×" in the repellency evaluation.

As shown in FIG. 6A, the rating "o" means the condition in which the protective layer is not repelled and the separate film is not exposed, i.e., the protective layer is uniformly formed.

As shown in FIG. 6B, the rating "Δ" means the condition in which, although part of the protective layer is uniformly formed, the protective layer is repelled and the separate film is partially exposed, i.e., the protective layer is not uniformly formed.

As shown in FIG. 6C, the rating "×" means the condition in which the protective layer is repelled as a whole and the separate film is exposed, i.e., the protective layer is not uniformly formed.

The rating "o" causes no practical problems, while the rating "Δ" and the rating "×" cause practical defects.

### <Evaluation of peel strength after thermocompression bonding>

SHM101-PUR available from Sheedom Co., Ltd., which serves as an adhesive resin, was applied to the protective layer of each of the laminates according to the examples and the comparative examples to a thickness of 10 µm using a wire bar, whereby an adhesive resin layer was formed.

Next, each of the laminates according to the examples and the comparative examples was placed on a corresponding polyimide base material, with the adhesive resin layer being in contact with the base material, and each workpiece was subjected to thermocompression bonding using a press under the conditions including a temperature of 150°C, a time period of five seconds, and a pressure of 0.5 MPa.

After the laminate returned to room temperature, the peel strength of the separator was measured using a peel strength tester (Palmec Co., Ltd., PFT50S). The measurement was performed under the conditions including room temperature, a tensile rate of 1000 mm/min, and a peel angle of 170°. The measurement was performed 10 times and the average was calculated. The results are shown in Tables 1 and 2.

As shown in Table 1, the separators according to Examples 1 to 6, in each of which the release surface has a water contact angle of 107.1° or greater and the protective layer contains polyurethane resin or poly-polyamide-imide resin, exhibited a good rating in the appearance evaluation and a low peel strength after thermocompression bonding.

As shown in Table 2, the separators according to Comparative Examples 1 to 3, in each of which the release surface has a water contact angle of 107.1° or greater but the protective layer contains none of polyurethane resin, polyamide-imide resin, and polyamide resin, exhibited a poor rating in the appearance evaluation.

Also, as shown in Table 2, the separators according to Comparative Examples 4 to 8, in each of which the protective layer contains polyurethane resin but the release surface has a water contact angle smaller than 107.1°, exhibited a poor rating in the appearance evaluation.

### REFERENCE SIGNS LIST

10, 11: laminate
20: separator
21: substrate
22: silicone resin film
22a: release surface
30: protective layer
40: conductive material layer
50: adhesive resin layer
60: base material
70: printed wiring board

## Claims

1. A laminate comprising:
a separator including a substrate and a silicone resin film disposed on a surface of the substrate, the silicone resin film serving as a release surface; and
a protective layer deposited on the separator and in contact with the release surface,
the release surface having a water contact angle of 107.1° or greater,
the protective layer containing at least one resin selected from the group consisting of polyurethane resin, polyamide-imide resin, and polyamide resin.

2. The laminate according to claim 1, further comprising a conductive material layer deposited on the protective layer, the conductive material layer being positioned opposite the separator with the protective layer in between.

3. The laminate according to claim 2,
wherein the conductive material layer is a conductive paste layer for forming an electric circuit.

4. The laminate according to claim 2 or 3, further comprising an adhesive resin layer deposited on and covering the conductive material layer, the adhesive resin layer being positioned opposite the separator with the protective layer in between.

5. A method for producing a laminate, the method comprising:
a separator preparation step of forming, as a separator, a silicone resin film on a surface of a substrate, the silicone resin film serving as a release surface; and
a protective layer formation step of depositing a protective layer on the release surface,
wherein
in the separator preparation step, the silicone resin film is formed to cause the release surface to have a water contact angle of 107.1° or greater, and
the protective layer contains at least one resin selected from the group consisting of polyurethane resin, polyamide-imide resin, and polyamide resin.

6. A method for producing a printed wiring board, the method comprising:
a laminate preparation step of preparing a laminate, the laminate including:
a separator including a substrate and a silicone resin film deposited on a surface of the substrate, the silicone resin film serving as a release surface;
a protective layer disposed on the separator and in contact with the release surface,
a conductive material layer deposited on the protective layer, the conductive material layer being positioned opposite the separator with the protective layer in between, and
an adhesive resin layer deposited on and covering the conductive material layer, the adhesive resin layer being positioned opposite the separator with the protective layer in between;
a laminate placement step of placing the laminate such that the adhesive resin layer is bonded to a base material;
a thermocompression bonding step of thermocompression-bonding the laminate to the substrate, and
a peeling step of peeling the separator,
the release surface having a water contact angle of 107.1° or greater, and
the protective layer containing at least one resin selected from the group consisting of polyurethane resin, polyamide-imide resin, and polyamide resin.
